Europäisches Patentamt

European Patent Office

Office européen des brevets

(19)

(11) Publication number: **0 188 834 B1**

# EUROPEAN PATENT SPECIFICATION

(45) Date of publication of patent specification: **31.07.91** (51) Int. Cl.5: **H03K 19/177**, H03K 19/017

(21) Application number: **85201979.3**

(22) Date of filing: **27.11.85**

(54) A ratioless FET programmable logic array.

(30) Priority: **21.12.84 US 684638**

(43) Date of publication of application:
**30.07.86 Bulletin 86/31**

(45) Publication of the grant of the patent:
**31.07.91 Bulletin 91/31**

(84) Designated Contracting States:
**DE FR GB IT NL**

(56) References cited:
**GB-A- 2 138 189**
**US-A- 4 346 310**
**US-A- 4 611 133**

**IEEE JOURNAL OF SOLID-STATE CIRCUITS,
vol. SC-16, no. 2, April 1981, pages 103-107,
IEEE; CHONG MING LIN: "A 4 mum NMOS
NAND structure PLA"**

**IEEE INTERNATIONAL SOLID-STATE CIR-
CUITS CONFERENCE, DIGEST OF PAPERS,
10th February 1982, pages 60-61, IEEE; G.
GRASSL et al.: "A self-testing PLA"**

(73) Proprietor: **N.V. Philips' Gloeilampenfabrieken
Groenewoudseweg 1
NL-5621 BA Eindhoven(NL)**

(72) Inventor: **Mahmud, Syed Tayyeb
c/o INT. OCTROOIBUREAU B.V. Prof. Holst-
laan 6
NL-5656 AA Eindhoven(NL)**

(74) Representative: **Faessen, Louis Marie Huber-
tus et al
INTERNATIONAAL OCTROOIBUREAU B.V. 6
Prof. Holstlaan
NL-5656 AA Eindhoven(NL)**

## Description

This is an invention in integrated circuits. In particularly, the invention concerns a logic array including a plurality of FETs connected in sets to perform AND functions and OR functions, each FET having a gate and first and second conducting regions, the gates of said AND FETs serving as inputs for said logic array, a separate column conductor for each AND set connecting together one of the conducting regions of each FET in its associated AND set, a separate row conductor for each OR set connecting together the first conducting region of each FET in its associated OR set, selection means selecting a particular combination of one or more AND sets for operation in conjunction with the operation of one or more OR sets. From e.g. the digest papers of the ISSCC, 10$^{th}$ of February 1982, pages 60-61 it is known that programmable logic arrays are arranged in two matrices usually referred to as the AND and OR matrices or the AND and OR arrays. The matrices show vertical and horizontal conductors called columns and rows. Field effect transistor (FET) programmable logic arrays (PLAs) have been made with a resistance ratio between their input and their load transistors. These usually operate by precharging only one array, either the AND array along the vertical column conducting lines or the OR array along the horizontal row conducting lines. FET PLAs are also known which operate by precharging both the AND array and the OR array but these require multiple clock signals and/or additional logic circuitry between the AND and OR arrays to operate properly.

It is an object of this invention to provide a ratioless FET PLA in which both its AND and OR arrays are precharged.

It is a further object of the invention to provide a self-timed PLA, which does not require multiple clock signals or additional logic between its AND and OR arrays in order to operate.

Another object of the invention to provide a PLA, which operates without quiescent, i.e. direct current, power dissipation.

The invention is set forth in independent claim 1.

One of the advantages of the invention is that the FETs which comprise the arrays can be made of minimum size.

Other objects, features and advantages of the invention will become apparent to those skilled in the art from the following description when considered in conjunction with the appended claims and the accompanying drawing in which:

Figure 1 is a schematic diagram of an input circuit of the invention;

Figure 2 is a schematic diagram of a PLA comprising an AND or OR array of the invention, and

Figure 3 is a timing diagram of representative signals of the invention.

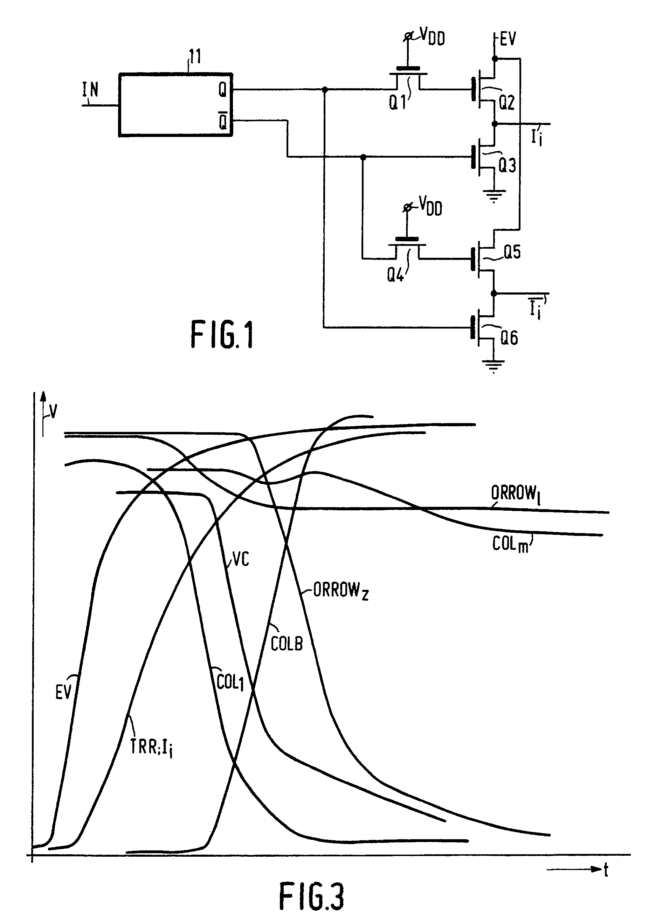

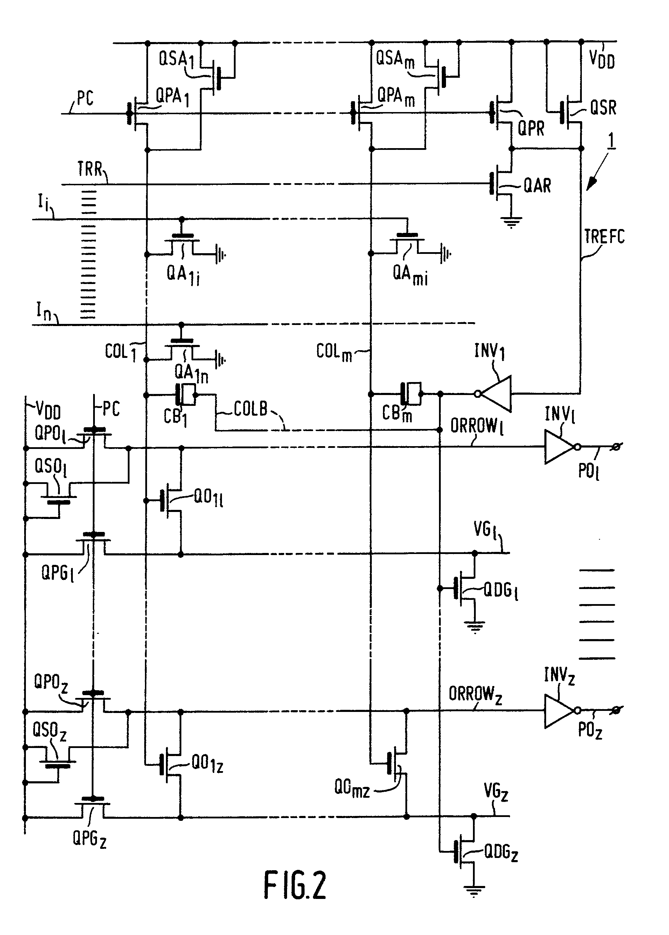

Referring to Figure 1, there is shown a latch 11 which produces a binary 1 output from terminal Q or $\overline{Q}$ depending upon whether a binary 1 signal or a binary 0 is applied along line IN. A binary 1 signal from output Q causes transistors Q1, Q2 and Q3 to produce a binary 1 along line $I_i$ whenever a binary 1 signal appears along line EV. At the same time a binary 0 is applied from output $\overline{Q}$ and transistors Q4, Q5 and Q6 produce a binary 0 along line $\overline{I_i}$. A binary 1 signal from output $\overline{Q}$ and a binary 0 from output Q when a binary 1 signal appears along line EV causes transistors Q1, Q2 and Q3 to provide a binary 0 along line $I_i$ and transistors Q4, Q5 and Q6 to produce a binary 1 along line $\overline{I_i}$. Binary 0's appear along both lines $I_i$ and $\overline{I_i}$ whenever a binary 0 appears on line EV. As is understood lines $I_i$ and $\overline{I_i}$ and other input lines are connected as inputs to the AND arrays as representatively shown for line $I_i$ in Figure 2.

Transistors Q1, Q2 and Q3 and transistors Q4, Q5 and Q6 comprise two AND gates whose inputs are the signal along line EV and the signals from outputs Q and $\overline{Q}$, respectively.

In Figure 2 an embodiment of a programmable logic array 1 in accordance with the invention has been shown.

Shown in Figure 2 are FETs $QA_{1i}$, $QA_{mi}$...$QA_{1n}$ which represent all of the FETs of the sets of FETs which perform an AND function. In the disclosed embodiment each AND FET is an n-channel IGFET. Also shown in Figure 2 are FETs $QO_{1l}$ $QO_{1z}$, $QO_{mz}$, which represent all of the FETs of the sets of FETs connected to perform an OR function. In the disclosed embodiment each OR FET is an n-channel IGFET. As those skilled in the art understand in accordance with the functions it is desired that the PLA 1 perform, the AND array will comprise one or more sets 1...n of FETs connected such as transistor $QA_{1i}$, $QA_{mi}$, $QA_{1n}$. Each separate AND set's FETs are connected in parallel between ground and an associated column conductor such as $COL_1$ and $COL_m$. Each column conductor such as $COL_1$, $COL_m$ connects together one of the conducting regions such as the drain of each FET such as $QA_{1i}$ in its associated AND set (e.g. $QA_{1n}$).

The OR array of the PLA 1 comprises a plurality of FETs such as $QO_{1l}$ connected in parallel between associated row conductors such as OR-$ROW_l$ and common conductor $VG_l$. Each row conductor such as $ORROW_l$; $ORROW_z$ connects together the first conducting region such as the drain of each FET such as $QO_{1l}$; $QO_{1z}$, $QO_{mz}$ in its associated OR set. Common conductor $VG_l$,$VG_z$ connects together the second conducting region such as the source of all FETs such as $QO_{1l}$, $QO_{1z}$, $QO_{mz}$, which perform an OR function in the PLA1.

It is also possible to interconnect all common conductors VG$_I$, VG$_z$.

Transistors QPA$_1$, QPO$_I$ and QPG$_I$ serve as means for precharging the column conductors such as COL$_1$, the row conductors such as ORROW$_I$ and the common conductor VG$_I$. If all common conductors VG$_I$ to VG$_z$ are interconnected only a single precharge transistor QPG will be necessary. If so the size of the PLA1 will be reduced. Transistors such as QPA$_1$...QPA$_m$, QSA$_1$...QSA$_m$, QPO$_I$...QPO$_z$ and QSO$_I$...QSO$_z$ are provided for each column 1...m and each row I...z in the PLA1. Transistor QPR provides a means for charging line TREFC to the voltage VDD. Transistor QAR provides a means for pulling line TREFC to ground upon the application of a binary 1 signal along line TRR. Transistors QSA$_1$...QSA$_m$ QSR and QSO$_I$...QSO$_z$ are high resistance devices used as sustaining transistors. If the cycle rate of the PLA$_1$ were fast enough to refresh the storage nodes before any leakage occurs these last mentioned devices may be eliminated thereby further reducing the size of the PLA$_1$.

A separate column boost capacitor such as CB$_1$...CB$_m$is provided for each column conductor COL$_1$.. COL$_m$ in the array. Column boost line COLB connects to the bottom plate of all the column boost capacitors such as CB$_1$ ... CB$_m$ of the PLA$_1$. Inverter INV1 applies a binary 1 signal to the gates of transistors QDG$_I$...QDG$_z$ and along column boost line COLB to the column boost capacitors such as CB$_1$...CB$_m$ upon the application of a binary 0 along line TREFC. Output inverters such as INV$_I$...INV$_z$ produce binary 1 signals along their associated output lines such as PO$_I$...PO$_z$ upon the application of a binary 0 along their associated row conductors such as ORROW$_I$...ORROW$_z$. A separate row conductor such as ORROW$_I$, an inverter such as INV$_I$ and an output line such as PO$_I$ is provided for each OR set I...z of the PLA$_1$.

In operation prior to an evaluation mode, with line EV low, lines PC go high and causes column conductors COL$_1$...COL$_m$, row conductors ORROW$_I$...ORROW$_z$ and common conductors VG$_I$...VG$_z$ approach V$_{DD}$ voltage. The precharging of common conductor VG$_I$...VG$_z$ allows OR array outputs such as ORROW$_I$...ORROW$_z$ to be precharged even though gates of its associated OR array transistors such as QO$_{1I}$ are at a binary 1 level (due to the precharge of the column conductors COL$_1$...COL$_m$). If the FETs QO$_{1I}$...QO$_{mz}$ have a sufficient high conductivity (have a sufficient width to length ratio) then the transistors QPG$_I$...QPG$_z$ can be dispensed with,

After the forementioned prechargings, lines PC go low and the evaluation mode can begin. To start an evaluation, line EV goes high (binary 1) keeping line I$_i$ low and causing line Ī$_i$ to go high (binary 1) provided a binary 0 is on output Q. (All, selected AND transistors have binary 0's on their gates via the selected I$_i$ lines since binary 0's are applied to the inputs of their associated latches such as 11 of Figure 1 select their associated transistors). At the same time that the unselected lines ($1 \leq i \leq n$) Ī$_i$ go high, line TRR goes high (binary 1) causing transistor QAR to turn on, A binary 0 on line I$_i$ and all other selected input lines keep transistor QA$_{1i}$...QA$_{mi}$ and all other selected transistors in the AND array turned off. Being turned off the selected transistors in the AND array cause their column conductors such as COL$_1$...COL$_m$ to remain high at approximately their precharge voltages. The column conductors for unselected transistors in the AND array are driven to ground (binary 0) by the fact that their unselected transistors are turned on (e.g. COL$_1$ is driven to ground if QA$_{1n}$ is turned on via unselected line I$_n$).

At the same time, transistor QAR drives line TREFC to ground after having been turned on by the binary 1 on line TRR. A binary 0 on line TREFC causes inverter INV1 to produce a binary 1 at its output. This produces a boosting voltage on both plates of the boost capacitors, such as CB$_1$...CB$_m$, associated with each of the selected AND array column such as COL$_1$...COL$_m$. As a result the selected columns such as COL$_m$ are maintained at a high voltage (see Figure 3). The unselected AND array columns e.g. COL$_1$ at this time are at ground (binary 0) by reason of their transitors QA$_{1n}$ being on. These columns, therefore, will discharge any coupled voltage on the top plate of their associated boost capacitors (CB$_1$) and stay at binary 0.

When transistors QDG$_I$...QDG$_z$ are turned on by the binary 1 at the output of inverter INV1, they drive common conductors VG$_I$...VG$_z$ to ground. This allows the OR FETs QO$_{mz}$ connected to selected columns to turn on and drive their associated conductors such as ORROW$_z$ to binary 0. Selected rows such as ORROW$_z$ by being driven to binary 0 cause their associated inverters such as INV$_z$ to produce binary 1's on the associated array output lines such as PO$_z$. The OR FETs QO$_{1z}$, QO$_{1I}$ associated with unselected columns COL$_1$ are not turned on and consequently their row lines ORROW$_I$ may remain at their precharged voltages (see Figure 3). As a consequence, the array outputs PO$_I$ associated with such rows remain at binary 0.

As can be seen, the inputs to the array such as I$_i$ act as a selection means which enable the selection of a particular combination of one or more AND sets for operation in conjunction with the operation of one or more OR sets in accordance with a particular function it is desired that the array perform.Included in the selection means are a delay means comprising transistor QAR, line TREFC, inverter INV1, boosting capacitors such as $CB_1...CB_m$, the precharge transistor $QPG_1...QPG_z$ common conductors $VG_1...VG_z$ and discharge transistors $QDG_1...QDG_z$. By designing the delay means to operate more slowly than any AND set in the PLA the delay means delays the operation of all of the OR sets associated with any particular function of the PLA until the selected one or more AND sets associated with that function have all operated.

It is to be understood by those skilled in the art that the disclosed array may be implemented in NMOS or CMOS.

Various modifications of the above arrangement will be evident to those skilled in the art. In one of these a delay circuit could be substituted for transistors QAR, QPR and QSR and inverter INV1. This delay circuit would be operated when the signal on line TRR goes high and after its delay would provide a boosting voltage on all selected boosting capacitors such as $CB_1...CB_m$.

From the foregoing it can be seen that there is no quiescent or direct current power dissipation in this PLA.

It is to be understood that the arrangement described herein is for illustrative purposes and is not to be considered restrictive.

## Claims

1. A logic array including a plurality of FETs (QA,QQ) connected in sets to perform AND functions and OR functions, each FET having a gate and first and second conducting regions, the gates of said AND FETs (QA) serving as inputs for said logic array, a separate column conductor (COL) for each AND set connecting together one of the conducting regions of each FET in its associated AND set, a separate row conductor (ORROW) for each OR set connecting together the first conducting region of each FET in its associated OR set, selection means (I) selecting a particular combination of one or more AND sets for operating in conjunction with the operation of one or more OR sets, the logic array including a common conductor (VG) connecting together second conducting regions of all FETs performing an OR function, and precharging (QPA,QPO) precharging said column conductors and row conductors, characterized in that said precharging of said column conductors and said row conductors takes place simultaneously, said selection means including delay means (QAR,TREFC,INV$_1$,CB,QPG,VG,QDG) the delay means being actuated in synchronism with the signals on the inputs of said logic array, for delaying the operation of all said one or more OR sets associated with a particular function until said selected one or more AND sets associated with that function have all operated.

2. A logic array according to Claim 1, characterized in that said delay means includes means (QDG) for discharging said common conductor line prior to the operation of said one or more OR sets.

3. A logic array according to Claim 2, characterized in that said selection means includes a boosting capacitor (CB) for each column conductor, each said capacitor associated with a selected AND set being charged by the operation of said delay means to assure proper operations of the selected one or more AND sets.

4. A logic array according to Claim 3, characterized in that said delay means includes a pulldown transistor (QAR) whose output is connected to an inverter (INV$_1$) the operating time of said transistor and inverter being longer than the operating time of any AND set in the array.

5. A logic array according to Claim 4, characterized in that said delay means includes a FET (QDG) which is turned on by the operation of said inverter to connect said common conductor to ground.

6. A logic array according to Claim 5, characterized in that during each operation all selected AND sets and all selected OR sets have their gates precharged whereby no quiescent or d.c. power is dissipated in the array during operation.

7. A logic array according to Claim 1, characterized in that the common conductors are precharged via FETs (QPG) in the OR sets during precharge of the row-conductors.

## Revendications

1. Réseau logique comprenant une pluralité de transistors à effet de champ (QA, QO) connectés en jeux pour remplir des fonctions ET et des fonctions OU, chaque transistor à effet de champ comportant une grille ainsi qu'une première et une seconde région conductrice, les grilles des transistors à effet de champ ET (QA) servant d'entrées pour le réseau logique, un conducteur de colonne séparé (COL) pour chaque jeu ET assurant l'interconnexion de l'une des régions conductrices de chaque transistor à effet de champ dans son jeu ET associé, un conducteur de rangée séparé (ORROW) pour chaque jeu OU assurant l'interconnexion de la première région conductrice de chaque transistor à effet de champ dans son jeu OU associé, un moyen de sélection (I) sélectionnant une combinaison particulière d'un ou de plusieurs jeux ET en vue de les faire fonctionner conjointement avec le fonctionnement d'un ou de plusieurs jeux OU, le réseau logique comprenant un conducteur commun (VG) interconnectant les secondes régions conductrices de tous les transistors à effet de champ exécutant une fonction OU, et des moyens de précharge (QPA, QPO) préchargeant les conducteurs de colonne et les conducteurs de rangée, caractérisé en ce que la précharge des conducteurs de colonne et des conducteurs de rangée s'effectue simultanément, le moyen de sélection comprenant un moyen à retard (QAR, TREFC, INV₁, CB, QPG, VG, QDG), ce moyen à retard étant actionné en synchronisme avec les signaux présents sur les entrées des réseaux logiques pour retarder le fonctionnement du ou des jeux OU associés à une fonction particulière, jusqu'à ce que le ou les jeux ET sélectionnés avec cette fonction aient tous fonctionné.

2. Réseau logique suivant la revendication 1, caractérisé en ce que le moyen à retard comprend un moyen (QDG) pour décharger la ligne du conducteur commun avant le fonctionnement du ou des jeux OU.

3. Réseau logique suivant la revendication 2, caractérisé en ce que le moyen de sélection comprend un condensateur survolteur (CB) pour chaque conducteur de colonne, chaque condensateur associé à un jeu ET sélectionné étant chargé sous l'intervention du moyen à retard pour assurer un fonctionnement adéquat du ou des jeux ET sélectionnés.

4. Réseau logique suivant la revendication 3, caractérisé en ce que le moyen à retard comprend un transistor chuteur (QAR), dont la sortie est connectée à un inverseur (INV₁), le temps de fonctionnement du transistor et de l'inverseur étant plus long que celui d'un jeu ET quelconque du réseau.

5. Réseau logique suivant la revendication 4, caractérisé en ce que le moyen à retard comprend un transistor à effet de champ (QDG) qui est rendu conducteur sous l'intervention de l'inverseur pour connecter le conducteur commun à la masse.

6. Réseau logique suivant la revendication 5, caractérisé en ce que, pendant chaque opération, tous les jeux ET sélectionnés et tous les jeux OU sélectionnés sont préchargés à leurs grilles, de sorte qu'aucun courant de repos ou continu n'est dissipé dans le réseau pendant le fonctionnement.

7. Réseau logique suivant la revendication 1, caractérisé en ce que les conducteurs communs sont préchargés par l'intermédiaire de transistors à effet de champ (QPG) dans les jeux OU pendant la précharge des conducteurs de rangée.

**Patentansprüche**

1. Logische Anordnung mit einer Vielzahl gruppenweise verbundener Feldeffekttransistoren (QA, QO) zum Ausführen von UND-Funktionen und ODER-Funktionen, wobei jeder Feldeffekttransistor ein Gate und erste und zweite Durchlaßbereiche besitzt, die Gates der UND-Feldeffekttransistoren (QA) als Eingänge für die logische Anordnung dienen, ein getrennter Spaltenleiter (COL) für jede UND-Gruppe einen der Durchlaßbereiche jedes Feldeffekttransistors in seiner zugeordneten UND-Gruppe zusammenschaltet, ein getrennter Zeilenleiter (ORROW) für jede ODER-Gruppe den ersten Durchlaßbereich jedes Feldeffekttransistors in seiner zugeordneten ODER-Gruppe zusammenschaltet, Wählmittel (I) eine besondere Kombination einer oder mehrerer UND-Gruppen zum Arbeiten im Zusammenhang mit dem Betrieb einer oder mehrerer ODER-Gruppen wählen, die logische Anordnung mit einem gemeinsamen Leiter (VG) zweite Durchlaßbereiche aller eine ODER-Funktion ausführenden Feldeffekttransistoren zusammenschaltet, und Vorlastmittel (QPA, QPO) die Spaltenleiter und Zeilenleiter voraufladen, dadurch gekennzeichnet, daß dieses Voraufladen der Spaltenleiter und Zeilenleiter gleichzeitig erfolgt, wobei die Wählmittel Verzögerungsmittel (QAR, TREFC, INV₁, CB, QPG, VG, QDG) enthalten, die synchron mit den Signalen an den Eingängen der logischen Anordnung zum Verzögern des Betriebs aller einen oder mehreren, einer besonderen Funktion zugeordneten ODER-Gruppen aktiviert werden, bis alle einen oder mehreren, dieser Funktion zugeordneten UND-Gruppen in Betrieb gewesen sind.

2. Logische Anordnung nach Anspruch 1, dadurch gekennzeichnet, daß die Verzögerungsmittel Mittel (QDG) enthalten zum Entladen des gemeinsamen Leiters vor dem Betrieb der einen oder mehreren ODER-Gruppen.

3. Logische Anordnung nach Anspruch 2, dadurch gekennzeichnet, daß die Wählmittel für jeden Spaltenleiter einen Zusatzkondensator (CB) enthält, wobei sich jeder derartige, einer ausgewählten UND-Gruppe zugeordnete Kondensator im Betrieb der Verzögerungsmittel auflädt, um einen geeigneten Betrieb der ausgewählten einen oder mehreren UND-Gruppen zu gewährleisten.

4. Logische Anordnung nach Anspruch 3, dadurch gekennzeichnet, daß die Verzögerungsmittel einen Abziehtransistor (QAR) enthalten, dessen Ausgang mit einer Umkehrstufe ($INV_1$) verbunden ist, wobei die Betriebszeit des Transistors und der Umkehrstufe länger ist als die Betriebszeit irgendeiner UND-Gruppe in der Anordnung.

5. Logische Anordnung nach Anspruch 4, dadurch gekennzeichnet, daß die Verzögerungsmittel einen Feldeffekttransistor (QDG) enthalten, der im Betrieb der Umkehrstufe eingeschaltet wird, um den gemeinsamen Leiter an Masse zu legen.

6. Logische Anordnung nach Anspruch 5, dadurch gekennzeichnet, daß in jedem Betrieb die Gates sämtlicher ausgewählter UND-Gruppen und die Gates sämtlicher ausgewählter ODER-Gruppen voraufgeladen sind, wobei im Betrieb in der Anordnung keine Ruheleistung oder Gleichstromleistung verbraucht wird.

7. Logische Anordnung nach Anspruch 1, dadurch gekennzeichnet, daß beim Voraufladen der Zeilenleiter die gemeinsamen Leiter über Feldeffekttransistoren (QPG) in den ODER-Gruppen voraufgeladen werden.

FIG.1

FIG.3

FIG.2

EP 0 188 834 B1

8